# EUROPÄISCHE PATENTANMELDUNG

(11) **EP 1 032 043 A2**
(43) Veröffentlichungstag der Anmeldung: **30.08.2000**
(21) Anmeldenummer: 00103078.2
(22) Anmeldetag: 15.02.2000
(51) Int. Cl.: H01L 27/108, H01L 23/522

(54) **Halbleiterspeicheranordnung mit Bitleitungs-Twist**

(30) Priorität: 26.02.1999 DE 19908428
(71) Anmelder: Infineon Technologies AG, 81541 München (DE)
(72) Erfinder: Feurle, Robert, 85579 Neubiberg (DE); Mandel, Sabine, 81369 München (DE); Savignac, Dominique, Dr., 85737 Ismaning (DE); Scheidner, Helmut, 80993 München (DE)
(74) Vertreter: Zedlitz, Peter, Dipl.-Ing.

(57) **Zusammenfassung**

Die Erfindung betrifft eine Halbleiterspeicheranordnung mit Wortleitungen (WL1 bis WL5) und Bitleitungen (BL1 bis BL5), bei der twistfreie Bitleitungen (BL3, BL4, BL7, BL8) mit Dummy-Kontakten (8 bis 11) versehen sind, die zu der Wortleitungsebene führen, so daß die Wortleitungen eine homogene Umgebung haben.

## Beschreibung

Die vorliegende Erfindung bezieht sich auf eine Halbleiterspeicheranordnung mit Wortleitungen und Bitleitungen, die über einem Speicherzellenfeld geführt sind, wobei Bitleitungen mit Bitleitungs-Twist neben Bitleitungen ohne Bitleitungs-Twist verlaufen und jeweils ein Bitleitungspaar mit Bitleitungs-Twist Kontakte zur Überkreuzung der einen Bitleitung durch die andere Bitleitung des Bitleitungspaares in einer von der Bitleitungsebene verschiedenen weiteren Ebene hat.

Bitleitungen werden bekanntlich über Speicherzellenfeldern mit Bitleitungs-Twist und ohne Bitleitungs-Twist geführt. Ein Bitleitungs-Twist hat den Vorteil, daß die beiden durch den Twist einander überkreuzenden Bitleitungen kapazitiv symmetrisch gekoppelt sind, so daß mögliche Störsignale einander aufheben. Außerdem heben sich dabei auch die Einkopplungen von Nachbarleitungen auf, wenn es sich um gefaltete bzw. "folded" Bitleitungen handelt.

Die Überkreuzung von zwei Bitleitungen in einem Twist setzt voraus, daß eine der Bitleitungen im Abstand und elektrisch isoliert über die andere Bitleitung geführt ist. Dies kann beispielsweise in der Weise geschehen, daß die eine Bitleitung im Überkreuzungsbereich zur anderen Bitleitung durch Kontakte in die Wortleitungsebene angehoben ist, so daß in diesem Kreuzungsbereich die eine Bitleitung in der Wortleitungsebene verläuft, während die andere Bitleitung auf der Bitleitungsebene verbleibt.

Benachbarte Bitleitungen sollten sich gegenseitig möglichst wenig beeinflussen, d.h., die elektrische Kopplung zwischen solchen benachbarten Bitleitungen sollte soweit als möglich verringert werden. Dies kann nun grundsätzlich dadurch geschehen, daß die Bitleitungen in einem größeren Abstand und ohne Twist bzw. Überkreuzung zueinander geführt sind. Ein solcher größerer Abstand ist aber zwangsläufig mit einem erheblich gesteigerten Flächenbedarf für das Speicherzellenfeld verbunden.

Zur Vermeidung des großen Abstandes wird der oben erläuterte Twist eingeführt: die Bitleitungen können nun enger nebeneinander verlaufen, wobei durch die zwangsläufig vorhandene kapazitive Kopplung eingeführte Störungen einander infolge des Twists aufheben. Bevorzugt werden derzeit Halbleiterspeicheranordnungen eingesetzt, bei denen paarweise Bitleitungen twistfrei und mit einem Twist versehen sind. Das heißt, auf zwei Bitleitungen mit Twist folgen zwei Bitleitungen ohne Twist. Es hat sich gezeigt, daß durch eine derartige Gestaltung der Bitleitungen eine Optimierung hinsichtlich Verringerung der Auswirkungen der kapazitiven Kopplung infolge des Twists von jedem zweiten Bitleitungspaar und Vereinfachung der Schaltungsstruktur infolge notwendiger Überkreuzungen für jedes zweite Paar bei reduziertem Flächenbedarf zu erzielen ist.

Ein Nachteil einer derart gestalteten Halbleiterspeicheranordnung liegt jedoch darin, daß in der Wortleitungsebene die einzelnen Wortleitungen an verschiedenen Stellen unterschiedliche Nachbarschaftseffekte erfahren, da nur im Bereich der Bitleitungspaare mit Twist die einen Bitleitungen mit ihren Kontakten in die Wortleitungsebene geführt sind. Es treten hier also in unerwünschter Weise unterschiedliche und inhomogene Beeinflussung der Wortleitungen im Überkreuzungsbereich der Bitleitungen auf.

Es ist daher Aufgabe der vorliegenden Erfindung, eine Halbleiterspeicheranordnung der eingangs genannten Art so zu verbessern, daß bei minimalem Flächenbedarf eine maximale elektrische und geometrische Symmetrie vorliegt, so daß ungleichmäßige Beeinflussungen von Randelementen, speziell Wortleitungen, im Überkreuzungs- oder Twistbereich der Bitleitungen vermieden werden.

Diese Aufgabe wird bei einer Halbleiterspeicheranordnung mit Wortleitungen und Bitleitungen, die über einem Speicherzellenfeld geführt sind, wobei Bitleitungen mit Bitleitungs-Twist neben Bitleitungen ohne Bitleitungs-Twist verlaufen und jeweils ein Bitleitungspaar mit Bitleitungs-Twist Kontakte zur Überkreuzung der einen Bitleitung durch die andere Bitleitung des Bitleitungspaares in einer von der Bitleitungsebene verschiedenen weiteren Ebene hat, erfindungsgemäß dadurch gelöst, daß die Bitleitungen ohne Bitleitungs-Twist mit zu der weiteren Ebene führenden Dummy-Kontakten versehen sind.

Die weitere Ebene ist dabei in vorteilhafter Weise die Wortleitungsebene. Die Bitleitungen haben im twistfreien Bereich eine Breite von etwa 150 bis 250 nm, vorzugsweise von 200 bis 225 nm, während die Bitleitungen im Twistbereich selbst etwa 250 bis 350 nm, vorzugsweise 330 nm, breit sind. Der Abstand zwischen den Bitleitungen bzw. deren Kontakten und den Bitleitungen beträgt etwa 150 bis 200 nm.

Durch die Dummy-Kontakte haben Randelemente in der weiteren Ebene, die im Twistbereich an die Kontakte der Bitleitungen angrenzen, die gleiche elektrische "Umgebung", so daß hier unterschiedliche Nachbarschaftseffekte vermieden werden.

Die Bitleitungen können so bei hoher Flächeneffizienz äußerst homogen und elektrisch sowie geometrisch weitgehend symmetrisch geführt werden, so daß keine Probleme mit Randelementen im Überkreuzungsbereich verursacht werden.

Das unter den Bitleitungen liegende Speicherzellenfeld ist dabei im Bereich der Überkreuzung bzw. des Twists vollständig regelmäßig, so daß sich auch hier keine zusätzlichen Randbereiche ergeben und die Einführung spezieller Randelemente nicht erforderlich ist. Durch die enge Führung der Bitleitungen nebeneinander wird außerdem Flächenbedarf in angestrebter Weise gering gehalten.

Nachfolgend wird die Erfindung anhand der Zeichnungen näher erläutert. Es zeigen:
- Fig. 1: eine Draufsicht auf Bitleitungen mit Twist und ohne Twist in der Bitleitungsebene und
- Fig. 2: eine vergrößerte Draufsicht auf den Twistbereich in der Wortleitungsebene.

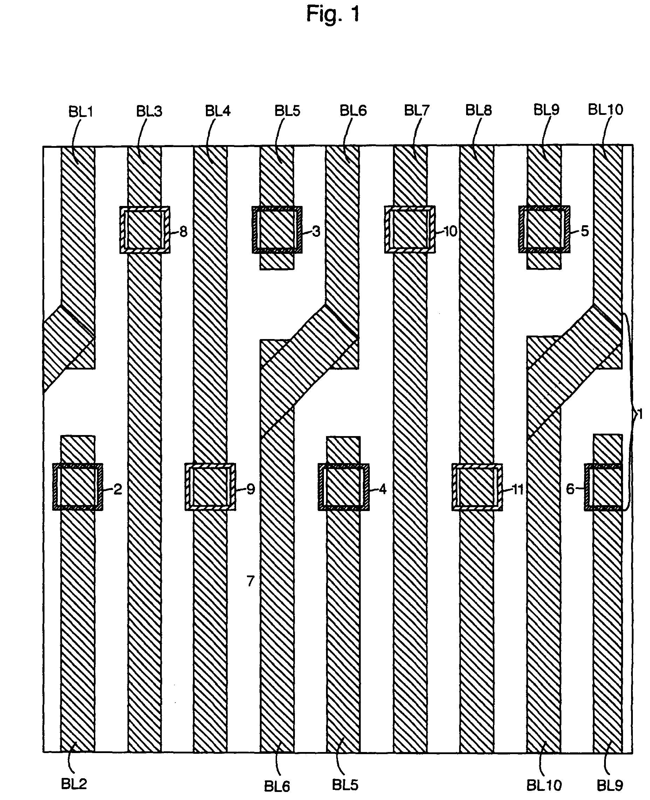

Fig. 1 zeigt Bitleitungen BL1 bis Bl10, von denen die Bitleitungen BL1 und BL2, BL5 und BL6 sowie BL9 und BL10 Bitleitungen mit Bitleitungs-Twist sind, während die Bitleitungen BL3 und BL4 sowie BL7 und BL8 twistfreie Bitleitungen darstellen. Mit anderen Worten, die Bitleitung BL2 überkreuzt die Bitleitung BL1, die Bitleitung BL5 überkreuzt die Bitleitung BL6, und die Bitleitung LB9 überkreuzt die Bitleitung BL10 jeweils in einer von der dargestellten Bitleitungsebene verschiedenen, höher gelegenen Ebene. Während also die Bitleitungen BL1, BL6 und BL10 in einem Twist- bzw. Überkreuzungsbereich 1 versetzt geführt sind, werden die Bitleitungen BL2 (obere Hälfte ist in Fig. 1 nicht gezeigt), die Bitleitung BL5 sowie die Bitleitung BL9 mittels Kontakten 2 bzw. 3, 4 bzw. 5, 6 in eine darüberliegende Ebene angehoben, um in dieser höher gelegenen Ebene im Twistbereich 1 die Bitleitungen BL1 bzw. BL6 bzw. BL10 zu überkreuzen.

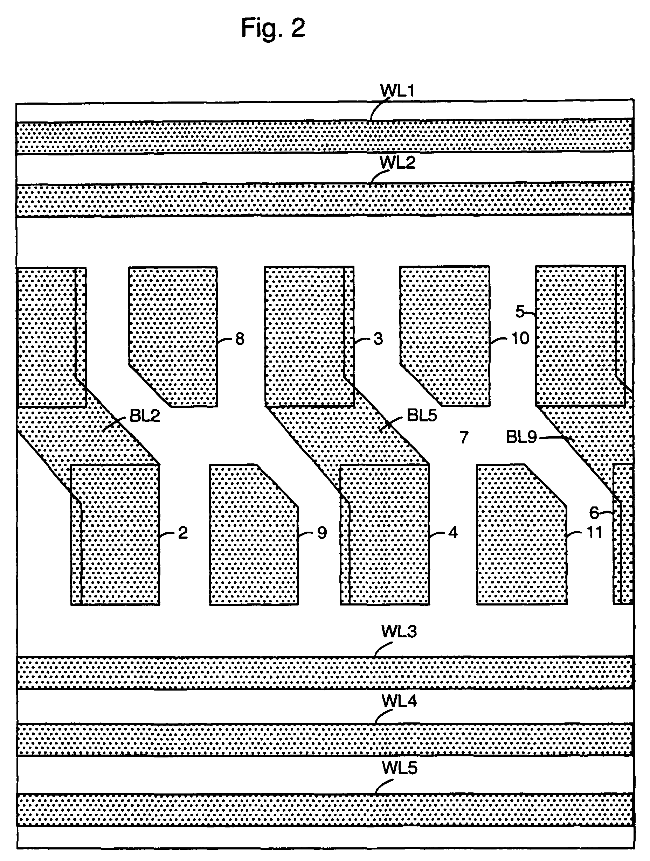

Diese höher gelegene Ebene ist vergrößert in Fig. 2 dargestellt, welche eine Wortleitungsebene mit Wortleitungen WL1 bis WL5 zeigt. Unterhalb der Kreuzungen zwischen den Wortleitungen WL1 bis WL5 mit den Bitleitungen BL1 bis BL10 sind in einem Speicherzellenfeld 7 nicht näher dargestellte Speicherzellen aus beispielsweise einem Transistor und einem Kondensator angeordnet.

Fig. 2 zeigt nun den Verlauf der Bitleitungen BL2, BL5 und BL9 in der Wortleitungsebene: die Bitleitung BL5 verläuft beispielsweise von dem Kontakt 3 in der höher gelegenen Wortleitungsebene im Abstand schräg über die Bitleitung BL6 im Twistbereich 1, um über den Kontakt 4 wieder auf die Bitleitungsebene (Fig. 1) zurückgeführt zu werden. Gleiches gilt für die Bitleitungen BL2 und BL9 mit den Kontakten 5 und 6 für beispielsweise die Bitleitung BL9.

Die Wortleitung WL2 hat auf diese Weise eine inhomogene "Nachbarschaft": sie grenzt an den in der Fig. 2 oberen Kontakt der Bitleitung BL2 und die Kontakte 3 bzw. 5 der Bitleitungen BL5 sowie BL9 an, während im Zwischenraum zwischen diesen Kontakten ein metallisierungsfreier Raum vorliegt. Gleiches gilt für die Wortleitung WL3, die zwischen den Kontakten 2, 4 und 6 kontaktfreie Zonen hat.

Diese Inhomogenitäten in der Nachbarschaft der Wortleitungen WL2 sowie WL3 wirken sich nachteilhaft auf das elektrische Verhalten der Halbleiterspeicheranordnung aus. Ebenso ist diese inhomogene Gestaltung für die Herstellung unvorteilhaft, da die Metallisierungen Diskontinuitäten zeigen.

Zur Vermeidung von durch solche Diskontinuitäten oder Inhomogenitäten verursachten Nachbarschaftseffekte ist nun erfindungsgemäß vorgesehen, daß auch die geraden Bitleitungen BL3, BL4 bzw. BL7, BL8, die keine Überkreuzungen bzw. Twists zeigen, mit Dummy-Kontakten 8 bis 11 versehen sind, also mit Kontakten, die von der Bitleitungsebene (Fig. 1) nach "oben" bis zur Wortleitungsebene (Fig. 2) führen und dort enden. Auf diese Weise ist sichergestellt, daß die Wortleitungen WL2, WL3 eine kontinuierliche und homogene Nachbarschaft zeigen, so daß die genannten Diskontinuitäten vermieden werden.

Die Erfindung ermöglicht so bei hoher Dichte der Bitleitungen und damit bei minimalem Flächenbedarf eine maximale elektrische und geometrische Symmetrie, bei der das unter den Bitleitungen liegende Speicherzellenfeld im Twistbereich 1 vollständig regelmäßig ist. Es ergeben sich damit keine zusätzlichen Randbereiche, und die Einführung spezieller Randelemente ist nicht erforderlich.

Es sei noch angemerkt, daß anstelle der Wortleitungen WL2, WL3 auch andere Strukturen vorgesehen sein können. Auch in diesem Fall werden diese Strukturen dann durch die Homogenität der Kontakte 2, 9, 4 und 11 bzw. 8, 3, 10 und 5 optimal beeinflußt, was auf die maximal mögliche Symmetrie zurückzuführen ist.

Für die Wortleitungen und die Bitleitungen sowie für die Kontakte kann beispielsweise Aluminium oder Kupfer als Material verwendet werden. Selbstverständlich sind jedoch auch andere Materialien einsetzbar.

Die Bitleitungen BL1 bis BL10 sind im twistfreien Bereich etwa 150 bis 250 nm und vorzugsweise etwa 200 bis 225 nm breit, während sie in dem Twistbereich 1 eine Breite von 250 nm bzw. 350 nm und insbesondere von etwa 330 nm haben können. Die Kontakte selbst weisen einen Durchmesser von etwa 400 nm auf, während der Abstand zwischen den Bitleitungen 150 bis 200 nm betragen kann.

## Patentansprüche

1. Halbleiterspeicheranordnung mit Wortleitungen (WL1 bis WL5) und Bitleitungen (BL1 bis BL10), die über einem Speicherzellenfeld (7) geführt sind, wobei Bitleitungen (BL1; BL5, BL6; BL9, BL10) mit Bitleitungs-Twist neben Bitleitungen (BL3, BL4; BL7; BL8) ohne Bitleitungs-Twist verlaufen und jeweils ein Bitleitungspaar (BL1, BL2; BL5, BL6; BL9, BL10) mit Bitleitungs-Twist Kontakte (2; 3, 4; 5, 6) zur Überkreuzung der einen Bitleitung (BL1; BL6; BL10) durch die andere Bitleitung (BL2; BL5; BL9) des Bitleitungspaares in einer von der Bitleitungsebene (Fig. 1) verschiedenen weiteren Ebene (Fig. 2) hat,
**dadurch gekennzeichnet,** daß die Bitleitungen (BL3, BL4, BL7, BL8) ohne Bitleitungs-Twist mit zu der weiteren Ebene führenden Dummy-Kontakten (8, 9, 10, 11) versehen sind.

2. Halbleiterspeicheranordnung nach Anspruch 1,
**dadurch gekennzeichnet,** daß die weitere Ebene die Wortleitungsebene ist.

3. Halbleiterspeicheranordnung nach Anspruch 1 oder 2,
**dadurch gekennzeichnet,** daß die Breite die Bitleitungen (BL1 bis BL10) im twistfreien Bereich etwa 150 nm bis etwa 250 nm beträgt.

4. Halbleiterspeicheranordnung nach Anspruch 3,
**dadurch gekennzeichnet,** daß die Breite der Bitleitungen (BL1 bis BL10) im twistfreien Bereich etwa 200 mm beträgt.

5. Halbleiterspeicheranordnung nach einem der Ansprüche 1 bis 4,
**dadurch gekennzeichnet,** daß die Breite der Bitleitungen (BL1 bis BL10) im Twistbereich (1) etwa 250 nm bis etwa 350 nm beträgt.

6. Halbleiterspeicheranordnung nach Anspruch 5,
**dadurch gekennzeichnet,** daß die Breite der Bitleitungen im Twistbereich etwa 330 nm beträgt.

7. Halbleiterspeicheranordnung nach einem der Ansprüche 1 bis 6,
**dadurch gekennzeichnet,** daß der Abstand zwischen den Bitleitungen etwa 150 bis 180 nm beträgt.

8. Halbleiterspeicheranordnung nach einem der Ansprüche 1 bis 7,
**dadurch gekennzeichnet,** daß die Bitleitungen (BL1 bis BL10), die Wortleitungen (WL1 bis WL10) und die Kontakte (2 bis 6, 8 bis 11) aus Aluminium oder Kupfer bestehen.
